Europäisches Patentamt

European Patent Office

Office européen des brevets

(19)

(11) Publication number: 0 335 663
A2

# EUROPEAN PATENT APPLICATION

(21) Application number: 89303055.1

(22) Date of filing: 28.03.89

(51) Int. Cl.⁴: **H 05 K 13/04**
**H 05 K 13/08**

(30) Priority: 29.03.88 US 174645

(43) Date of publication of application:
04.10.89 Bulletin 89/40

(84) Designated Contracting States:
AT BE CH DE ES FR GB IT LI NL SE

(71) Applicant: **RAYCHEM CORPORATION**
**300 Constitution Drive**
**Menlo Park California 94025 (US)**

(72) Inventor: **Carlomagno, William D.**
**2071 Goodwin Avenue**
**Redwood City, CA 94061 (US)**

**Shanley, John F.**
**30 Pellican Lane**
**Redwood City California 94065 (US)**

**Diaz, Stephen H.**
**482 Everett Avenue**
**Palo Alto California 94301 (US)**

**Cherian, Gabe**
**52 Amorok Way**
**Fremont California 94538 (US)**

(74) Representative: **Jay, Anthony William et al**
**Raychem Limited Intellectual Property Law Department**
**Faraday Road**
**Dorcan Swindon Wiltshire (GB)**

(54) A protected electronic component.

(57) An electronic component (2) having interconnection wires (4) attached to contacts on its surface is mounted on an apertured support sheet (12), with the wires extending through and protruding from the apertures (8). The component may be tested electrically while mounted on the support sheet. The end portions of the wires that protrude from the support sheet are preferably severed to produce straight wires of equal length. The wires may be severed by means of an apertured auxiliary sheet (14) in surface-to-surface contact with the support sheet. The protruding end portions of the wires are inserted into the apertures (10) in the auxiliary sheet, and the support and auxiliary sheets are moved laterally relative to one another to sever the wires.

EP 0 335 663 A2

## Description

## A PROTECTED ELECTRONIC COMPONENT

This invention relates to a method of making an assembly which comprises an electronic component mounted on a substrate, a method of forming interconnection wires on respective contacts on an electronic component, a socket for protecting an electronic component, and a protected electronic component.

WO-A-88/04829 discloses a technique for interconnecting electronic components such as integrated circuit (IC) chips, chip carriers and printed circuit boards. An interconnection wire is bonded to a contact on an electronic component without the use of a material other than the materials of the contact and the wire, for example by the application of heat and pressure to form a weld. The wire is severed to leave a free end extending in a direction away from the contact, preferably in a direction that is substantially perpendicular to the contact at the point at which it is bonded thereto. The interconnection wire is preferably bonded to a contact on another component by means of a conductive material that is different from the materials of the wire and of that contact, for example a solder. The conductive material may be located in recesses, one on each contact.

It is desirable to be able to test an electronic component before it is installed for use, for example by electrical connection to a circuit board. This is particularly desirable in the case of IC chips and other complicated chips which can often be faulty, and whose faults can be difficult to identify once the component has been incorporated into a complicated piece of equipment.

During the manipulative steps between providing interconnection wires on a first electronic component, and bonding the wires to contacts on a second component (which steps might include for example testing, burning in the component, and transportation), the interconnection wires are liable to be damaged, particularly since they can have a diameter as small as 75 micrometers or less. It is highly desirable that they are not bent or otherwise damaged prior to bonding to a second component since this can make more difficult the accurate connection of the wires to their respective contacts on the second component.

We have found that manipulative steps between providing interconnection wires on a first electronic component and bonding the wires to contacts on a second component are facilitated by using one or more sheets which have apertures formed therein into which the interconnection wires can be inserted.

In one aspect, the invention provides a method of making an assembly which comprises an electronic component mounted on a substrate, the method comprising:

(a) providing an electronic component having contacts on a surface through which electrical connection can be made to the component, and wires attached to the contacts;

(b) inserting the free ends of the wires into respective apertures in a support sheet; and

(c) removing the wires from the apertures in the support sheet and electrically connecting the wires to respective contacts on a substrate.

The method of the invention allows an electronic component which has interconnection wires on a surface to be manipulated, for example to be transported, burned in or electrically tested, with significantly reduced risk of damage to the wires. This is particularly advantageous since, frequently, interconnection wires are provided on a first component at a first location, and the first component is connected to a second component at a second location. The protection afforded by the support sheet removes the need for particularly careful handling of the component during transportation between the first and second locations.

It is preferred that the electronic component is a packaged component in which:

(i) contacts on the component have interconnection wires bonded thereto, for example for connection to contacts on other components; and

(ii) the bonds between the interconnection wires and the contacts, and sensitive surface regions of the component, are sealed against ingress of contaminants, such as moisture and conductive connection materials.

The seal may be provided by a layer of insulating material on the component, through which the interconnection wire or wires extend.

When the component is not a packaged component, a seal against ingress of contaminants may be provided once the component is mounted in the support sheet, for example by means of a casing.

The interconnection wires provided on the electronic component will generally be provided in a pattern which substantially corresponds to the pattern of the apertures in the support sheet. Preferably the wires will be substantially straight (although they may be curled provided that they are maintained a sufficient distance apart to avoid contact with one another or with contacts on other conductive elements which would lead to a short circuit) and will extend away from the contacts substantially parallel to one another. This is preferably arranged by applying force to each wire after it has been bonded to its respective contact, the direction in which the force is applied being substantially parallel to the direction in which force is applied to the or each neighboring wire on the component. Force may be applied to the wire by applying tension to it. Preferably the application of force to the wire results in the wire being deformed plastically. In addition to straightening and orientating the wires, the application of force thereto ensures that the bond between the wires and their respective contacts are tested mechanically, and can also work-harden the material of the wire. Work hardening the material of the wire can restore metallurgical characteristics which might previously have been adversely affected, for example when the wire was heated to cause it to bond to the contact.

The present invention therefore provides a method by which delicate wires may be bonded to contacts on an electronic component in a desired configuration, suitable for subsequent connection to another component, and may then be protected from subsequent damage which might disturb that configuration adversely.

The contact on the surface of the component, to which the interconnection wire is connected, may be in the form of, for example, a pad, or an end of a conductive trace which runs parallel or perpendicular (or at an angle between the two) to the surface, such as a via. It may be recessed, coplanar with the surrounding surface of the component, or it may stand proud of the surface.

The wire which is used to form interconnection wires will be as fine as possible consistent with the mechanical and electrical requirements placed upon it when in use, and on the requirements for handling it and for bonding it to the contacts. Generally, the wire will be substantially round and will have a diameter of less than about 375 micrometers (microns), prefereably less than about 250 microns. Particularly preferred wire has a diameter of from about 12 to about 125 microns, especially from about 25 to about 75 microns.

The material of the wire will be selected according to the techniques by which the interconnection between it and the contacts on the electronic components are to be made. The wire should preferably be capable of bonding to the material of one of the contacts without the use of another material, and for this reason, aluminum, gold and copper wires are preferred, hard drawn gold wire being particularly preferred.

The bond between the wire and the contact is preferably made without the use of a material other than the materials of the contact and the wire, and will generally be a weld. The bond may be formed by the application of one or a combination of heat, pressure and vibration, for example, by thermocompression bonding which utilizes a combination of heat and pressure, or by thermosonic or ultrasonic bonding which utilize a combination of heat, pressure and vibration. It will be understood that incidental amounts of materials other than the materials of the wire and the contact, such as for example surface preparation agents, reaction products and contaminants such as oxide coatings and the like, may be present in or around the bond.

The bond may be formed between the circumferential surface of the wire and the contact, the wire being bent adjacent to the bonded portion so that it extends away from the contact.

More preferably, however, the bond is formed between the end of the wire and the contact. For example, the bond may be formed by heating the wire at or near its end to form a ball. The bond is then formed between the ball and the contact. Heat may be applied to the end of the wire by means of an electric arc extending between an electrode and the wire. The wire may be supplied from the wire bonder through a bonding head which is generally referred to as a capillary and which has a through passage through which the wire passes. This technique is generally known as "ball bonding".

Generally, one wire is attached to each contact on the component, although for some applications more than one wire may be provided on one or more contacts. Each aperture in the support sheet will generally receive a wire or wires from a single contact on the component, but may receive wires from more than one contact.

Preferably the free ends of the wires that are inserted into the apertures in the support sheet are so inserted that at least some, preferably all, extend through and protrude from the sheet. This allows electrical connection to be made to one portion of the interconnection wires while another portion is protected from damage. For example, the interconnection wires may be lead to respective contacts on a surface, and held against the contacts while the component in question is in use or is being tested. The wires may be forced against the contacts by a resilient element such as a block of elastomeric material, or they may be bonded to the contacts, for example by means of a conductive material such as a solder.

The method of the invention preferably includes the step of severing the portions of the wires that protrude from the support sheet. It is envisaged also, however, that electrical connection may be made to the interconnection wires within the support sheet, in which case it will not be necessary for the wires to protrude from the sheet.

In another aspect, the invention provides a method of forming interconnection wires on respective contacts on an electronic component, which comprises:

(a) providing an electronic component having contacts on a surface through which electrical connection can be made to the component, and wires attached to the contacts;

(b) inserting the free ends of the wires into respective apertures in a support sheet so that at least some of the wires extend through and protrude from the sheet; and

(c) severing the portions of the wires that protrude from the support sheet.

Severing the wires that protrude from the support sheet has the advantage that it allows the wires to be prepared in a predetermined configuration depending on the surface of the support sheet from which they protrude. For example by using a planar support sheet disposed parallel to the contact bearing surface of the component, it is possible to prepare interconnection wires of equal length, or if not disposed parallel to that surface, having lengths that increase from one region of the component towards another. The ability to obtain interconnection wires having a controlled length is highly desirable since accurate connection of the wires to contacts on a second electronic component generally requires that the lengths of the wires be equal or otherwise carefully controlled.

In yet another aspect, the invention provides a socket for protecting an electronic component having contacts on a surface through which electrical connection can be made to the component, and wires attached to the contacts, the socket comprising:

(a) a support sheet having apertures formed therein for receiving the free ends of the interconnection wires attached to the component;

(b) means for severing portions of the wires that extend through and protrude from the apertures.

The socket of the invention receives the electronic component as if it were a mateable plug; however, it includes means for severing the interconnection wires on the component, which can serve to modify the wires to make them suitable for a subsequent use in a process step.

The socket may include means for forming electrical connections to at least some of the wires to be inserted in the apertures in the support sheet. When the socket includes an auxiliary sheet, the connection means may comprise conductive material lining the apertures therein.

An auxiliary sheet may be used to sever the wires by relative lateral movement between the auxiliary sheet and the support sheet. To achieve this, the two sheets will preferably be in surface-to-surface contact.

The control over the step of severing the wires may be increased by use of a support sheet in which the ratio of the transverse dimension of the apertures at the surface from which the free ends of the wires protrude to the transverse dimension of the wires inserted (or to be inserted) therein is not more than 2.00, preferably not more than 1.50, especially not more than 1.25. Preferably the apertures in the support sheet are tapered inwardly towards the surface from which the free ends of the wires protrude. This facilitates insertion of the free ends of the wires into the apertures while still allowing control to be exerted over the lateral position, and therefore the lengths, of the wires when they are severed.

In a further aspect, the invention provides a protected electronic component, which comprises:

(a) an electronic component having contacts on a surface through which electrical connection can be made to the component, and wires attached to the contacts; and

(b) a support sheet having apertures therein, the free ends of the wires being inserted in the apertures so that at least some of the wires extend through and protrude from the sheet, the ratio of the transverse dimension of the apertures at the surface from which the free ends of the wires protrude to the transverse dimension of the wires being not more than 2.00, preferably not more than 1.50, especially not more than 1.25.

Generally the interconnection wires on the component will be circular in cross-section, as will the apertures in the support sheet. However, the cross-section of one or both may be non-circular; in this event, the transverse dimension will be the diameter of a circle which circumscribes the wire or aperture as the case may be.

Preferably the method of the invention includes the step of inserting at least some, preferably all, of the wires that protrude from the support sheet into apertures in an auxiliary sheet disposed substantially parallel to the support sheet. The apertures in the auxiliary sheet may be open in the sense that the wires are able to extend through and protrude from the sheet, or they may be closed in the form of recesses.

The apertures in the auxiliary sheet may have constant cross-sections and axes which are perpendicular to the plane of the sheet. This has the advantage that the wires can be inserted into the apertures without the exertion of force. Each of the apertures may present to the inserted wires a face that is inclined to the axis of insertion. The face may be contacted by a wire as it is inserted into its aperture, the insertion generally requiring the exertion of force to bend the wire. Otherwise, an inclined face of an aperture may contact a wire inserted therein when the support and auxiliary sheets are moved relative to one another. Indeed, the provision of apertures with inclined faces allows the sheets to be moved laterally relative to one another, even when the sheets are in surface to surface contact, so as to bend wires inserted therein rather than to shear them. Advantages of bending the wire are recited below. For example the apertures may be of constant cross-section, having an axis that is inclined to the plane of the sheet. Alternatively or in addition, the apertures may be tapered at least along a portion of their length. The apertures in the auxiliary sheet may comprise a plurality of portions, each presenting surfaces having different orientations. For example, the apertures may have a zig-zag con figuration. Such configurations of aperture can optimize electrical contact between wires inserted in the apertures and conductive material located therein.

The leading portion of the apertures preferably has a constant cross-section and an axis that is perpendicular to the plane of the sheet. This can help to straighten wires when withdrawn from the apertures, and thus can remove the need to cut off portions of wires that have been bent while inserted in the apertures.

It is particularly preferred that the apertures in both the support sheet and the auxiliary sheet are tapered inwardly. The use of sheets whose aperture configurations are identical facilitates manufacturing. When desired for testing, the apertures in one of the sheets, preferably the auxiliary sheet, may be provided with a conductive material to permit electrical connection to wires inserted therein.

Several auxiliary sheets may be used in the form of a laminate. Separate severing means may be associated with each of some or all of the auxiliary sheets to allow interconnection wires inserted in apertures therein to be severed to progressively shorter lengths, for example to permit a series of different tests to be performed on the component.

The method preferably includes the step of moving the support sheet and the auxiliary sheet laterally relative to one another. Such movement can be used to grip the interconnection wires for example to retain the wires in the apertures in the support sheet.

Preferably the support sheet, or the auxiliary sheet when present, comprises means for making an electrical connection to the interconnection wires. For example, the apertures in one of the sheets may be provided with a conductive material, within the sheet or on a surface thereof. The apertures may be lined with a conductive material such as a metal or a conductive elastomeric material. Such a lining may be applied by plating; a first layer of a metal lining may be applied by electroless plating or by vapour deposition, and subsequent layer may be applied by electrolytic plating. Preferably the metal comprises copper, silver or gold. When copper is used, it is preferred that a thin passivating layer of an inert metal such as nickel be applied over it. A further layer of gold may be applied over the nickel layer to establish contact with low resistance between the metal lining and wires inserted therein.

The apertures may be blocked with a flexible conductive material such as an elastomeric material, in particular a gel. The flexible conductive material may be contacted by the wires when inserted into the apertures in a surface-tosurface sense, or it may be penetrated by the wires; the flexible material may block the apertures, either within the apertures or on a surface of the sheet. The flexible material within the apertures may be particulate such as a metal powder; when a metal powder is used it may be desirable to employ a seal to prevent dispersion of the powder, a suitable seal comprising a gel gasket.

Conductive material may be provided on resilient arms mounted relative to each aperture such that each arm is deformed by a wire as it is inserted into its respective aperture.

Preferably the conductive material is associated with, especially provided in, the apertures in the auxiliary sheet, since the sheet to which connections are made can then be removed after the component has been tested and before the wires are severed. This reduces the chance of fragments of the wire material becoming trapped in the apertures in the auxiliary sheet, which could lead to the formation of a short circuit or other electrical fault between the apertures.

Electrical connections between the wires and conductive material located in apertures in one of the sheets is preferably caused by bending the wires, taking advantage of the compliance of the wires. The use of the ability of the wires to bend in making an electrical connection has the advantage that it is possible to accommodate tolerances in the manufacture of the sheet and of the component, which otherwise can reduce the reliability of connection between the wires and conductive material located in each of the apertures. The wires may be bent using a support sheet and an auxiliary sheet by moving the sheets laterally relative to one another; for this purpose, the sheets may be spaced apart, or the apertures in the auxiliary sheet will present a face to the wires that is inclined to the surface of the support sheet as explained above, or both. In another embodiment, the apertures in one of the sheets may be so configured that the wires are bent when inserted therein; for example, the apertures in the auxiliary sheet may have an inclined wall with which the wires come into wiping contact when inserted into the apertures.

The wires may be bent plastically or elastically, depending on the extent to which they are bent and on the material of the wires. It is preferred that any portion of the wires that is deformed plastically be removed by severing.

Electrical connection between the wires and conductive material located in apertures in one of the sheets can also result from relative lateral movement of the sheets to cause the wires to be gripped by the two sheets. By careful control of the relative movement, it can be arranged to sever the wires partially. This is particularly appropriate when the sheets are in surface-to-surface contact. Further relative movement of the sheets can sever the wires, for example to produce wires of equal length.

Preferably, the ratio of the diameter of each aperture in the support sheet to the diameter of the interconnection wire is not more than about 2.0, more preferably not more than about 1.5.

The thickness of the sheets will preferably be less than about 1mm, more preferably less than about 750 micrometers, especially less than about 500 micrometers. The thickness may, however, be outside this range according to the desired length of the wires.

The extent to which the support and auxiliary sheets are moved to make an electrical connection to the wires will depend on the distance between the sheets, the relative sizes of the apertures in the sheets and the wires, and the extent to which the pattern of wires on the component does not correspond to the pattern of apertures in the sheets. For example, when the wires have a diameter of about 50 micrometers, the apertures have a minimum diameter of about 75 micrometers, and the sheets are substantially in surface-to-surface contact, the relative movement of the sheets will be through about 25 micrometers.

The sheet which has a conductive material in the apertures therein may comprise means for forming electrical connections between the interconnection wires on the component and one or more contacts on a component of electrical testing equipment for testing certain characteristics of the electronic component. For example the sheet may have posts to be received in appropriately spaced holes in a printed circuit board. Alternatively, or in addition, the sheet may have circuit elements mounted on it for testing the component, connections between the circuit elements and the wires on the component being made through the conductive material in the apertures.

The protected electronic component of the invention preferably includes means for severing portions of the interconnection wires that extend through and protrude from the support sheet. When the end portions of the wires are inserted into apertures in an auxiliary sheet, the wires may be severed by a shear action caused by relative lateral movement of the support and auxiliary sheets. This has the advantage that electrical contact to the wires for testing can be made by a small amount of relative movement of the sheets, and that once testing of the component is complete, the wires can be severed to a desired length by additional continued relative movement (which may be in the same direc tion as the first small amount of movement, or in another direction).

It is preferred that the shearing surfaces of the support and auxiliary sheets are prepared so that they are smooth to facilitate shearing of the wires. For example, the surfaces may be prepared having surface asperities not more than about 1% of the diameter of the wire to be sheared, preferably not more than 0.5%, especially not more than about 0.1% of the diameter. More particularly, the surface asperities may be less than about 1.5 micrometers, preferably less than about 750nm especially less than about 150nm, more especially less than about 75nm.

Particularly, when the support and auxiliary sheets are required to shear the wires, it is preferred that they be resiliently biased towards one another. This may be achieved, for example by means of a leaf spring or a helical spring, or a block of resiliently deformable material, which acts between a fixture and one of the sheets.

The wires may be severed using a blade which is drawn across the surface of the support sheet from which the wires protrude. This has the advantage that fragments of the wire material are likely only to contaminate the support sheet and not also any auxiliary sheet. This can be important when the auxiliary component has conductive material in its apertures for forming electrical connections to the interconnection wires. The blade may be drawn across the support sheet in a space between the support sheet and the auxiliary sheet which are attached to one another in a parallel spaced apart relationship. This has the advantage that a component can be tested conveniently by moving the support and auxiliary sheets relative to one another, but that fragments of the wires are less likely to contaminate the auxiliary sheet when the wires are severed than when relative movement itself of the sheets is used to sever the wires. This advantage may also be attained by removing the auxiliary sheet when present to expose interconnection wires protruding from the apertures in the support plate, and cutting the wires using a blade. Restricting contamination by the material of the wires to the support plate has the advantage that removal of contamination is necessary only in respect of the support plate. This can be achieved by known cleaning treatments. This is particularly advantageous when the auxiliary plate bears electrically conductive material which might be sensitive to such treatment, and from which removal of contamination would therefore be more difficult.

Means used to sever the wires may be treated to control the smearing of the material of the wire during severing. For example, when the wires are cut by passing a blade across the surface of the support sheet, the surface or the blade, or more preferably both, may be treated with a material to which the material of the wires does not stick. When the wires comprise gold, rhodium is a suitable material.

When the support sheet provides a surface against which the interconnection wires are severed, it is preferred that it comprise a material that is harder than the material of the wires. Particularly preferred materials include organic and inorganic polymeric materials, especially ceramic and glass materials, and engineering plastics. Metals may be used as the material of the support sheet, when electrical requirements permit, particularly if treated to render the surface thereof electrically insulating. Apertures may be formed in the support sheet by physical or chemical treatment, such as drilling or etching. A particularly preferred material for the support sheet is a ceramic material that is sensitive to ultraviolet radiation, in that portions of the material that have been exposed thereto can be removed by chemical treatment. Such a material is sold by the Corning Glass Works under the trademark Fotoceram.

It will generally be preferred that one, (especially the support sheet) or more preferably both, of the sheets be rigid to the extent that they will not flex during use to such an extent that unacceptable variations in the lengths of the wires are introduced, and to minimize smearing of the material of the wires when sheared.

When the support sheet or the auxiliary sheet has conductive elements for forming connections to the interconnection wires, electrical requirements of the sheets may influence the choice of materials. Suitable materials for the insulating sheet include those which are suitable for the support sheet; indeed it is preferred that the same materials be used for the two sheets, with modifications where necessary to meet electrical requirements, such as the provision of an electrically conductive material in the apertures in one of the sheets.

The support sheet and auxiliary sheet are preferably located in one of two or more predetermined relative positions by means of one or more locking pins located in locking apertures in the two sheets. For example, locking apertures may be provided in the two sheets that are aligned when the apertures in the two sheets for receiving the interconnection wires are also aligned. One or more pins inserted in the locking apertures will lock the sheets in this position. Another set of locking apertures may be provided in the sheets which are aligned when the wire receiving apertures in the two sheets are positioned relative to one another such that wires inserted therein are gripped within the apertures, or are in electrical contact with conductive material lining the apertures in one of the sheets, or both. Preferably, the locking pins are tapered to facilitate insertion in the locking apertures. Preferably, the sheets are biased resiliently towards the first relative position.

Embodiments of the invention will now be described, by way of example with reference to the accompanying drawings, in which:

Figures 1 and 2 each show schematically a section through an electronic component mounted in a support sheet and auxiliary sheet assembly; and

Figure 3 is an isometric view of an electronic component mounted in a support sheet and auxiliary sheet assembly which is suitable for connection to a circuit board.

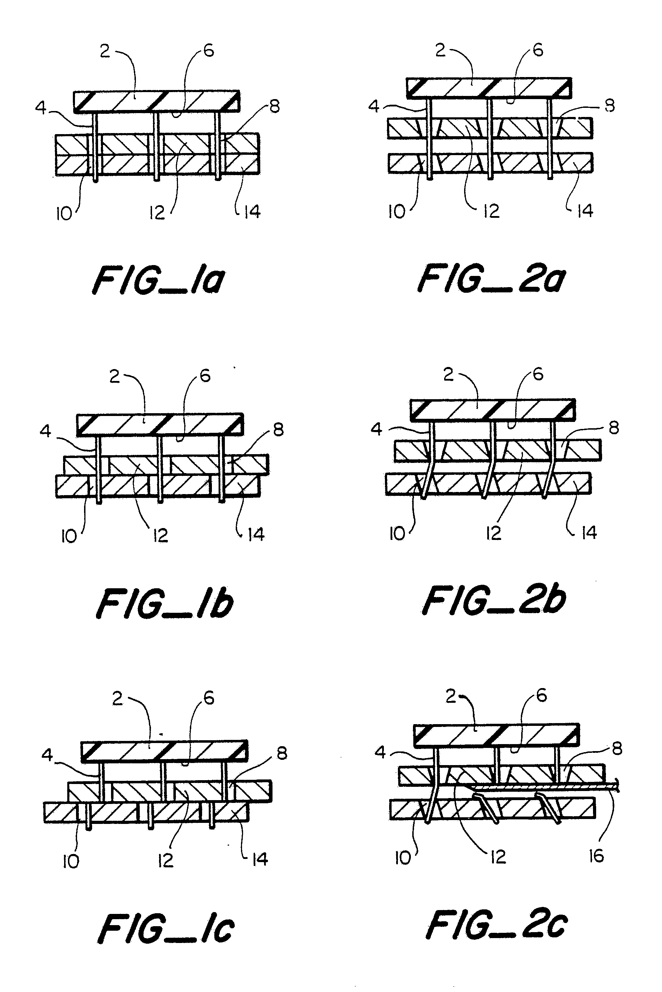

Referring to the drawings Figures 1 and 2 show an electronic component 2 such as an IC chip which has interconnection wires 4 bonded to contacts on a surface 6.

As shown in Figure 1a, the interconnection wires are inserted in apertures 8,10 in a support sheet 12 and an auxiliary sheet 14 respectively. In a preferred embodiment the apertures in the support sheet are tapered inwardly to assist insertion of the wires. This can be particularly valuable for components that have large number of interconnection wires bonded to them. Preferably, the apertures in the auxiliary sheet are also tapered inwardly, to assist insertion of the wires, and to allow the wires to bend when the sheets are moved relative to one another which would not otherwise be possible when the sheets are in surface to surface contact. Preferably the interconnection wires are round, and the ratio of the diameter of the apparatus to the diameter of the wires in the support sheet, at the surface from which the wires protrude, is less than 1.30.

As shown in Figure 1b, the support sheet 12 and the auxiliary sheet 14 have been moved laterally relative to one another, so that the interconnection wires 4 contact the walls of the apertures 8,10. By carefully controlling the movement, the wires can be sheared partially to ensure good contact between the wires and the aperture walls. The contact between the wires and the sheets can serve two purposes: it can serve to retain the wires within the apertures in the support sheet so that they are protected from physical damage during testing, burn-in and transportation of the component. Furthermore, if the apertures in one of the sheets, preferably the auxiliary sheet 14, are lined with a conductive material, for example with a layer of a metal provided by plating, the contact between the wires and that sheet can be used to transmit electrical signals between the component 2 and equipment for testing the component.

As shown in Figure 1c, further relative movement of the support and auxiliary sheets 12, 14 causes the interconnection wires 4 to be severed at the interface between the sheets. The use of a support sheet with an accurately machined face, and with apertures that are only slightly larger than the wires that protrude from them, allows the wires to be severed to a desired length, particularly to the same length. The wires 4 can then be removed from the apertures 8 in the support sheet 12 for connection to contacts on a second component, for example by means of solder located in respective recesses on the contacts.

The embodiment shown in Figure 2 differs from that shown in Figure 1 in that the support sheet 12 and auxiliary sheet 14 are spaced apart, while still able to slide laterally to one another. The apertures 8 in the support sheet 12 are tapered inwardly in a direction away from the component 2. The apertures 10 in the auxiliary sheet 4 have a constant cross-section and an axis that is inclined to the plane of the sheet. Alternatively, the apertures in the auxiliary sheet may be tapered inwardly in a direction away from the component.

As shown in Figure 2b., the contact between the interconnection wires 4 and the support and auxiliary sheets 12,14 is achieved by relative lateral movement of the sheet. Such movement causes the wires to bend and to engage the apertures 10 in the auxiliary sheet 14 at the openings thereof.

As shown in Figure 2c, the interconnection wires are severed by means of a blade 16 which is slidable between the support sheet 12 and the auxiliary sheet 14, in contact with the surface of the support sheet from which the wires 4 protrude.

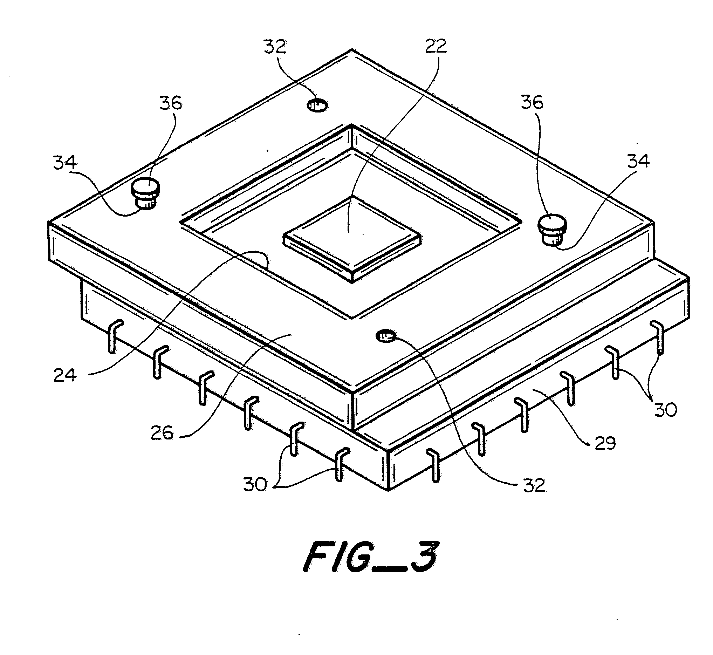

Figure 3 shows an electronic component 22 such as an IC chip mounted in a recess 24 in a support sheet 26 by means of interconnection wires which are inserted through apertures in the support sheet into apertures in an auxiliary sheet 29. The wires are held in the apertures as a result of the sheets having been moved laterally relative to one another, so that the interconnection wires are in electrical contact with conductive material lining the apertures in the auxiliary sheet. The auxiliary sheet has contacts 30 that are electrically connected to the conductive material in the apertures. The contacts can be inserted in appropriate recesses in a printed circuit board to allow the component 22 to be tested.

The support and auxiliary sheets are held in two relative positions by means of locking pins and locking apertures. In a first position, the apertures for receiving the wires are aligned to allow the wires to be inserted. In a second position, the apertures for receiving the wires are marginally out of alignment so that the wires are gripped (as shown in Figures 1b and 3). Locking apertures 32 receive a locking pin for locking the sheets in the first relative position. In the second position as shown, locking pins 36 are received in locking apertures 34.

## Claims

1. A method of making an assembly which comprises an electronic component mounted on a substrate, the method comprising:

(a) providing an electronic component (2) having contacts on a surface through which electrical connection can be made to the component, and wires (4) attached to the contacts;

(b) inserting the free ends of the wires into respective apertures (8) in a support sheet (12); and

(c) removing the wires from the apertures in the support sheet and electrically connecting the wires to respective contacts on a substrate.

2. A method as claimed in claim 1, which includes the step of applying force to each wire (4) in a direction away from the contact, the direction in which force is applied to each wire being substantially parallel to the direction in which force is applied to the or each neighboring wire, the force being applied to the wires before insertion thereof into the said apertures (8).

3. A method as claimed in claim 1 or claim 2, which includes the step of connecting the interconnection wires (4) to equipment for testing the electronic component while the wires are inserted into the apertures (8) in the support sheet.

4. A method as claimed in claim 3, in which connection to the interconnection wires (4) is made to portions thereof which protrude from the apertures (8) in the support sheet (12).

5. A method as claimed in any one of claims 1 to 4, in which the free ends the wires (4) are inserted into the apertures (8) in the support sheet (12) such that at least some extend through and protrude from the sheet.

6. A method as claimed in claim 5, which includes the step of inserting at least some of the wires (4) that protrude from the sheet (12) into apertures (10) in an auxiliary sheet (14) disposed substantially parallel to the support sheet (12).

7. A method as claimed in claim 6, which includes the step of moving the support sheet (12) and the auxiliary sheet (14) laterally relative to one another so as to grip the interconnection wires (4) that are inserted into the apertures (10) in the auxiliary sheet.

8. A method as claimed in claim 6 or claim 7, which includes the step of moving the support sheet (12) and the auxiliary sheet (14) laterally relative to one another so as to sever the portions of the wires (4) that protrude from the support sheet.

9. A method as claimed in claim 5, which includes the step of severing the portions of the wires (4) that protrude from the support sheet (12).

10. A method of forming interconnection wires (4) on respective contacts on an electronic component (2), which comprises:

(a) providing an electronic component (2) having contacts on a surface through which electrical connection can be made to the component, and wires (4) attached to the contacts;

(b) inserting the free ends of the wires into respective apertures (8) in a support sheet (12) so that at least some of the wires extend through and protrude from the sheet; and

(c) severing the portions of the wires that protrude from the support sheet.

11. A method as claimed in claim 10, which includes the step of inserting at least some of the wires (4) that protrude from the support sheet (12) into apertures (10) in an auxiliary sheet (14) disposed substantially parallel to the support sheet.

12. A method as claimed in claim 11, in which the wires (4) that are inserted into the apertures (10) in the auxiliary sheet (14) are severed by relative lateral movement of the support (12) sheet and auxiliary sheet.

13. A method as claimed in claim 11, in which the apertures (8, 10) in at least one of the support sheet (12) and the auxiliary sheet (14) contain conductive material through which connections can be made between the contacts on the electronic component (2), and other components that are connection to the said conductive material.

14. A method as claimed in claim 13, which includes the step of forming electrical connections between the wires (4) and the conductive material located in the apertures (10) in the auxiliary sheet (14), and electrically testing the electronic component by applying test signals to the conductive material.

15. A method as claimed in any one of claims 10 to 14, in which the wires (4) are attached to the contacts by means of welds.

16. A socket for protecting an electronic component (2) having contacts on a surface through which electrical connection can be made to the component, and wires (4) attached to the contacts, the socket comprising:

(a) a support sheet (12) having apertures (8) formed therein for receiving the free ends of the interconnection wires attached to the component;

(b) means (14) for severing portions of the wires that extend through and protrude from the apertures.

17. A socket as claimed in claim 16, which includes means for forming electrical connections to at least some of the wires to be inserted in the apertures in the support sheet.

18. A socket as claimed in claim 16 or claim 17, in which at least some of the apertures (8) in the support sheet (16) are tapered inwardly towards the surface from which the free ends of the wires (4) are to protrude.

19. A socket as claimed in any one of claims 16 to 18, which includes an auxiliary sheet (14) having apertures (10) formed therein for receiving the portions of the wires (4) that extend through and protrude from the support sheet (12).

20. A socket as claimed in claim 19, in which the support sheet (12) and auxiliary sheet (14) are so arranged relative to one another that the wires (4) can be severed by relative lateral movement of the support and auxiliary sheets.

21. A socket as claimed in claim 20, in which the support and auxiliary sheets (12, 14) are in surface-to-surface contact.

22. A socket as claimed in any one of claims 19 to 21, in which the apertures (10) in the auxiliary sheet (14) have electrically conductive material associated therewith, with which interconnection wires (4) inserted in the said apertures can form an electrical connection.

23. A socket as claimed in claim 22, in which the electrically conductive material lines the apertures (10) in the auxiliary sheet (14).

24. A socket as claimed in any one of claims 19 to 23, in which the apertures (10) in the auxiliary sheet (14) present a face to the interconnection wires (4) that is inclined to the axis along which the wires are inserted.

25. A socket as claimed in claim 22, in which the auxiliary sheet (14) has circuit elements mounted on it which are electrically connected to the said conductive material, for connection to the interconnection wires (4) when inserted into the apertures (10) therein.

26. A socket as claimed in any one of claims 16 to 25, which has interconnection wires (4), which are attached to contacts on a surface of an electronic component (2), inserted in the apertures (8) in the support sheet (12).

27. A socket as claimed in claim 26, in which the ratio of the transverse dimension of the apertures (8) at the surface of the support sheet (12) from which the free ends of the wires (4) protrude to the transverse dimension of the wires is not more than 2.0.

28. A socket as claimed in claim 21, in which the contacting surfaces of the support and auxiliary sheets (12, 14) have surface asperities of not more than about 1.5 micrometers.

29. A socket as claimed in claim 21, in which the support and auxiliary sheets (12, 14) are resiliently biased towards one another.

30. A protected electronic component, which comprises:

(a) an electronic component (2) having contacts on a surface through which electrical connection can be made to the component, and wires (4) attached to the contacts; and

(b) a support sheet (12) having apertures (8) therein, the free ends of the wires being inserted in the apertures so that at least some of the wires extend through and protrude from the sheet,

the ratio of the transverse dimension of the apertures at the surface from which the free ends of the wires protrude to the transverse dimension of the wires being not more than 2.0.

FIG_1a

FIG_2a

FIG_1b

FIG_2b

FIG_1c

FIG_2c

*FIG_3*